# EUROPÄISCHE PATENTANMELDUNG

(11) **EP 1 387 608 A1**
(43) Veröffentlichungstag der Anmeldung: **04.02.2004**
(21) Anmeldenummer: 03016285.3
(22) Anmeldetag: 18.07.2003
(51) Int. Cl.: H05K 7/14, H01R 9/26

(54) **Modular erweiterbares Hutschienengehäuse**

(30) Priorität: 31.07.2002 DE 20211822 U
(71) Anmelder: Endress + Hauser Wetzer GmbH + Co. KG, D-87484 Nesselwang (DE)
(72) Erfinder: Konrad, Michael, 87459 Pfronten (DE); Wolf, Georg, 87616 Marktoberdorf (DE)
(74) Vertreter: Andres, Angelika

(57) **Zusammenfassung**

Die Erfindung bezieht sich auf ein modular erweiterbares Gehäuse, insbesondere Hutschienengehäuse für den Einsatz in der Prozeßmeßtechnik/Prozeßregeltechnik. Das Gehäuse (2) weist eine vorgegebene Anzahl von Aufnahmeschächten (4) auf. Es ist eine entsprechende Anzahl von Einschubmodulen (14; 15) vorgesehen, die in die Aufnahmeschächte (4) einschiebbar sind. Jedem Einschubmodul (14; 15) ist eine lösbare Arretiervorrichtung (11) zugeordnet, über die jedes Einschubmodul (14; 15) in einem Aufnahmeschacht (4) arretierbar oder aus dem Aufnahmeschacht (4) entnehmbar ist

## Beschreibung

Die Erfindung bezieht sich auf ein modular erweiterbares Gehäuse. Insbesondere handelt es sich bei dem Gehäuse um ein Hutschienengehäuse, das in der Prozeßmeßtechnik/Prozeßregeltechnik zum Einsatz kommt.

Von der Anmelderin werden unter der Bezeichnung PRELINE unterschiedliche Typen von Prozeßmeßumformern für die unterschiedlichsten Anwendungsfälle angeboten. Bei dem Prozeßmeßumformer PRELINE RMA 422 handelt es sich um ein multifunktionales 1-2 kanaliges Hutschienengerät mit eigensicheren Stromeingängen und Meßumformerspeisung, Grenzwertüberwachung, Mathematikfunktionen und 1-2 Analogausgängen. U.a. dient der bekannte Prozeßmeßumformer der Temperaturanzeige und Temperaturüberwachung, der Prozeßerfassung und Prozeßüberwachung, der Prozeßsteuerung, der Signalanpassung und Signalwandlung sowie der Signalverdopplung. Er ist in der Lage, neue Prozeßgrößen durch verschiedene Rechenoperationen (Addition, Subtraktion, Mulitplikation) der Eingangssignale zu bilden. Der bekannte Meßumformer hat skalierbare Analogausgänge für Strom und Spannung, eine serielle Schnittstelle zum Datenaustausch, eine LC-Anzeige und Tasten für die Vorort-Bedienung bzw. Vorortanzeige.

Bei komplexen Anwendungen, wenn z.B. die Signale von einer Vielzahl von Feldgeräten verarbeitet werden müssen, sind üblicherweise mehrere Prozezβmeßumformer erforderlich. Die einzelnen Meßumformer müssen dann auf der Hutschiene befestigt werden, was bei den bekannten Lösungen den Einsatz von Werkzeugen notwendig macht.

Der Erfindung liegt die Aufgabe zugrunde, ein modular erweiterbares Gehäuse vorzuschlagen, das in einfacher Art und Weise an unterschiedliche in der Prozeßmeß- bzw. Prozeßregeltechnik gestellte Anforderungen anpaßbar ist.

Die Aufgabe wird dadurch gelöst, daß das Gehäuse eine vorgegebene Anzahl von Aufnahmeschächten aufweist, daß eine entsprechende Anzahl von Einschubmodulen vorgesehen ist, die in die Aufnahmeschächte einschiebbar sind, und daß jedem Einschubmodul eine lösbare Arretiervorrichtung zugeordnet, über die jedes Einschubmodul in einem Aufnahmeschacht arretierbar oder aus dem Aufnahmeschacht entnehmbar ist

Gemäß einer vorteilhaften Weiterbildung des erfindungsgemäßen Gehäuses ist vorgesehen, daß die Arretiervorrichtung im jeweils unteren Bereich eines Einschubmoduls bzw. an der Grundfläche des Gehäuses vorgesehen ist. Besonders einfach läßt sich die Arretiervorrichtung gestalten, wenn es sich hierbei um eine Schnappverbindung handelt. Hierzu sind gemäß einer günstigen Ausgestaltung an der Grundfläche des Einschubmoduls zwei Rastelemente, insbesondere zwei Schnapphaken vorgesehen, die in Arretierstellung in zwei entsprechende Aussparungen an der Grundfläche des Gehäuses einrasten.

Eine vorteilhafte Ausführungsform des erfindungsgemäßen Gehäuses sieht vor, daß es sich bei dem Einschubmodul um ein Steckkartenmodul oder um ein Blindmodul handelt. Bei dem Steckkartenmodul kann es sich z. B. um ein Modul zur Berechnung und/oder Anzeige einer Prozeß- oder Regelgröße, um ein Modul zur Anbindung des Sensors an einen Bus oder um ein Netzteil handeln.

Die Erfindung wird anhand der nachfolgenden Zeichnungen näher erläutert. Es zeigt:
Fig. 1: eine Explosionsdarstellung einer bevorzugten Ausführungsform des erfindungsgemäßen Gehäuses,
Fig. 2: eine Explosionsdarstellung des Tragrahmens mit zwei Steckkartenmodulen und einem Blindmodul,
Fig. 3: eine Explosionsdarstellung des Trägerrahmens mit einem Steckkartenmodul,
Fig. 4: eine Draufsicht auf das Gehäuse gemäß der Kennzeichnung A in Fig. 1,
Fig. 5: eine Draufsicht auf das Gehäuse gemäß der Kennzeichnung B in Fig. 1 und
Fig. 6: eine Seitenansicht eines Steckkarten- bzw. Blindmoduls.

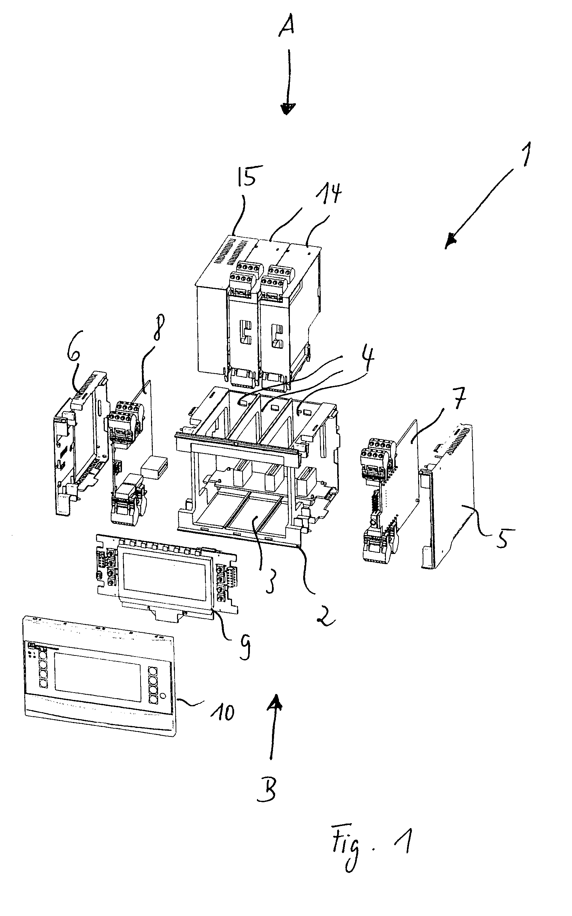

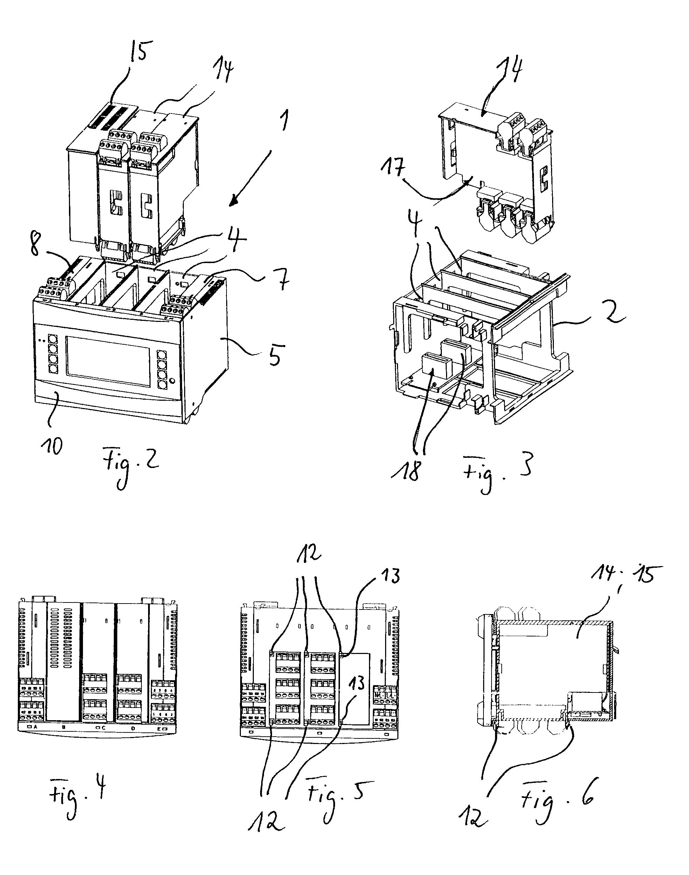

In den Figuren Fig. 1 bis Fig. 5 ist eine bevorzugte Ausgestaltung des erfindungsgemäßen modular aufgebauten Hutschienengehäuses 1 in unterschiedlichen Ansichten dargestellt. Fig. 1 zeigt eine Explosionsdarstellung einer bevorzugten Ausführungsform des erfindungsgemäßen Gehäuses 1, während Fig. 2 eine Explosionsdarstellung des montierten Gehäuses 1 mit den Einschubmodulen 14, 15 zeigt. Fig. 3 bezieht sich auf eine Explosionsdarstellung des Tragrahmens 3 mit nur einem Steckkartenmodul 14; 15. In Fig. 4 ist eine Draufsicht auf das Gehäuse 1 gemäß der Kennzeichnung A in Fig. 1 zusehen, Fig. 5 zeigt eine Draufsicht auf das Gehäuse 1 gemäß der Kennzeichnung B in Fig. 1. In Fig. 5 ist die Seitenansicht eines Steckkartenmoduls 14 bzw. Blindmoduls 15 dargestellt. Das erfindungsgemäße Gehäuse 1 ist beispielsweise für einen Dampf- und Wärmemengenrechner vorgesehen. Ein derartiger Rechner findet seine Anwendung in der Energiewirtchaft, in der chemischen und pharmazeutischen Industrie, in der Lebensmittelindustrie, in der Heizungs- und Klimatechnik und im Anlagen- und Apparatebau.

Das Gehäuse 1 weist drei Einschubschächte 4 für die Aufnahme von maximal drei Einschubmodulen 14 auf. Bei den Einschubmodulen 14 kann es sich um Steckkartenmodule handeln, welche z. B. zur Berechnung und/oder Anzeige einer Prozeß- oder Regelgröße oder zur Anbindung eines Sensors an einen Bus dienen. Auch kann es sich bei dem Steckkartenmodul um ein Netzteil handeln. Falls die Anzahl der Aufnahmeschächte 4 die Anzahl der benötigten Einschubmodule 14 übersteigt, ist ein Blindmodul 15 als Platzhalter vorgesehen.

Das Gehäuse 1 weist einen Tragrahmen 2 mit drei Aufnahmeschächten 4 auf. Die beiden Seitenwände 5, 6 mit den daran befestigten Leiterkarten 7, 8 können über einen Klickverschluß an dem Tragrahmen 2 befestigt werden. Die Anzeigeplatine 9 ist an der Vorderseite des Tragrahmens 2 befestigt. Vor der Anzeigeplatine 9 ist der Frontrahmen 10 positioniert. Insbesondere handelt es sich bei der Anzeigeeinheit um ein LC-Display. In den Aufnahmeschächten 4 des Tragrahmens 2 sind die Einschubmodule 14; 15 einzeln positionier- und arretierbar.

Ein Einschubmodul 14; 15 wird von oben in einen der Aufnahmeschächte 4 eingeführt. An der Grundfläche bzw. Unterseite des Einschubmoduls 14, 15 befinden sich zwei flexible Schnapphaken 12, die in entsprechende Aussparungen 13 an der Grundfläche 3 des Gehäuses 1 einrasten. Durch Zusammendrücken der beiden Schnapphaken 12 eines Einschubmoduls 14, 15 läßt sich die Arretierung in einfacher Weise lösen und das Einschubmodul 14, 15 kann durch einfaches Herausziehen aus dem Aufnahmeschacht 4 herausgenommen werden. Zwecks elektrischer Kontaktierung rastet die an einem Einschubmodul 14,15 vorgesehene Platinenzunge 17 in den Steckverbinder 18 der Busplatine ein.

### Bezugszeichenliste

- 1: erfindundsgemäßes Gehäuse
- 2: Tragrahmen
- 3: Grundfläche des Gehäuse
- 4: Aufnahmeschacht
- 5: Seitenwand
- 6: Seitenwand
- 7: Leiterkarte
- 8: Leiterkarte
- 9: Anzeigeplatine
- 10: Frontrahmen
- 11: Arretiervorrichtung / Schnappverbindung
- 12: Rastelement / Schnapphaken
- 13: Aussparung
- 14: Einschubmodul / Steckkartenmodul
- 15: Blindmodul
- 16: Grundfläche des Einschubmoduls
- 17: Platinenzunge
- 18: Steckverbinder auf Busplatine

## Patentansprüche

1. Modular erweiterbares Gehäuse, insbesondere Hutschienengehäuse für den Einsatz in der Prozeßmeßtechnik/Prozeßregeltechnik,
wobei das Gehäuse (2) eine vorgegebene Anzahl von Aufnahmeschächten (4) aufweist,
wobei eine entsprechende Anzahl von Einschubmodulen (14; 15) vorgesehen ist, die in die Aufnahmeschächte (4) einschiebbar sind, und
wobei jedem Einschubmodul (14; 15) eine lösbare Arretiervorrichtung (11) zugeordnet, über die jedes Einschubmodul (14; 15) in einem Aufnahmeschacht (4) arretierbar oder aus dem Aufnahmeschacht (4) entnehmbar ist.

2. Vorrichtung nach Anspruch 1,
wobei die Arretiervorrichtung (11) im jeweils unteren Bereich eines Einschubmoduls (14; 15) bzw. an der Grundfläche (3) des Gehäuses ( 2) vorgesehen ist.

3. Vorrichtung nach Anspruch 1 oder 2,
wobei es sich bei der Arretiervorrichtung (11) um eine Schnappverbindung handelt.

4. Vorrichtung nach Anspruch 1 oder 2,
wobei an der Grundfläche (16) des Einschubmoduls (14; 15) bevorzugt zwei Rastelemente (12), insbesondere zwei Schnapphaken vorgesehen sind, die in Arretierstellung in zwei entsprechende Aussparungen (13) an der Grundfläche (3) des Gehäuses (2) einrasten.

5. Vorrichtung nach Anspruch 1, 2 oder 4,
wobei es sich bei dem Einschubmodul (14) um ein Steckkartenmodul oder um ein Blindmodul (15) handelt.

6. Vorrichtung nach Anspruch 5,
wobei es sich bei dem Steckkartenmodul (14) um ein Modul zur Berechnung und/oder Anzeige einer Prozeß- oder Regelgröße handelt.

7. Vorrichtung nach Anspruch 5,
wobei es sich bei dem Steckkartenmodul (14) um ein Modul zur Anbindung des Sensors an einen Bus handelt.

8. Vorrichtung nach Anspruch 5,
wobei es sich bei dem Steckkartenmodul (14) um ein Netzteil handelt.
